# EUROPEAN PATENT APPLICATION

(11) **EP 2 159 855 A1**
(43) Date of publication of application: **03.03.2010**
(21) Application number: 08765311.9
(22) Date of filing: 03.06.2008
(51) Int. Cl.: H01L 35/32, H01L 35/34, H02N 11/00

(54) **THERMOELECTRIC CONVERSION MODULE, THERMOELECTRIC CONVERSION DEVICE, AND THEIR MANUFACTURING METHOD**

(30) Priority: 07.06.2007 JP 2007151900
(71) Applicant: Sumitomo Chemical Company, Limited, Tokyo 104-8260 (JP)
(72) Inventor: HIROYAMA, Yuichi, Tsukuba-shi Ibaraki 300-2617 (JP); NAKANE, Kenji, Tsukuba-shi Ibaraki 305-0045 (JP)
(74) Representative: Hart-Davis, Jason
(86) International application number: PCT/JP2008/060510
(87) International publication number: WO 2008/150006

(57) **Abstract**

The present invention provides a thermoelectric conversion module, a thermoelectric conversion unit and their manufacturing method. The thermoelectric conversion module comprising a substrate and a plurality of thermoelectric conversion devices arranged on the surface of the substrate, wherein the substrate is provided with a through hole formed to extend through the surface and the back thereof, and the thermoelectric conversion devices are arranged on at least one of the surface and the back of the substrate as to enclose the through hole. The thermoelectric conversion device comprising the thermoelectric conversion module, and a tube arranged to extend through the through hole of the thermoelectric conversion module and to allow a hot medium or a cold medium to flow therethrough. The method for manufacturing a thermoelectric conversion module comprises a thermoelectric conversion device arranging step of arranging a plurality of thermoelectric conversion devices on at least one of the surface and the back of a substrate having a through hole extending through the surface and the back thereof as to enclose the through hole.

## Description

### TECHNICAL FIELD

The present invention relates to a thermoelectric conversion module, a thermoelectric conversion unit and their manufacturing method.

### BACKGROUND ART

As a thermoelectric conversion module for carrying out power generation with a temperature difference between a tube through which a hot medium or cold medium flows and an atmosphere outside of the tube, a thermoelectric conversion module is known having a thermoelectric conversion material coated on the surface and the back of a annular member surrounding a tube and on the side face thereof (for example, JP-A-2006-228852).

### DISCLOSURE OF THE INVENTION

In conventional arts, however, it has been difficult to attain sufficient output. The present invention has been made to solve the above-described problem and has an object of providing a thermoelectric conversion module with a sufficient output used for a tube, a thermoelectric conversion unit and their manufacturing method.

The thermoelectric conversion module of the present invention comprises a substrate and a plurality of thermoelectric conversion devices arranged on the surface of the substrate. In the substrate a through hole is formed to extend through the surface and the back thereof. The thermoelectric conversion devices are arranged on the surface of the substrate as to enclose the through hole.

The thermoelectric conversion unit of the present invention comprises the above-described thermoelectric conversion module, and a tube arranged to extend through the through hole of the thermoelectric conversion module and to allow a hot medium or a cold medium to flow therethrough.

By arranging thermoelectric conversion devices on any face of the substrate so as to enclose the through hole as described above, thermoelectric conversion with a temperature difference between the through hole side of the substrate and the outer surface side thereof can be carried out efficiently by using many thermoelectric conversion devices arranged with high density.

It is preferable that each of the thermoelectric conversion devices has an elongated shape, and the thermoelectric conversion devices are arranged in centering around the through hole and radiating in all directions when viewed in a direction vertical to one face of the substrate so that the thermoelectric conversion device with higher density and higher output can be easily obtained by efficiently arranging the thermoelectric conversion devices around the through hole.

As to a width along a direction crossing the axis of the elongated shape in the thermoelectric conversion device, it is preferably that the width in a further position toward the radial direction from the center at which the through hole exists is larger when viewed in a direction vertical to one face of the substrate so that thermoelectric conversion devices can be arranged with higher density and the one face of the substrate can be efficiently coated with thermoelectric conversion devices.

It is preferable that the substrate is in the form of circular disk so that every temperature differences between thermoelectric conversion devices can be the same.

It is preferable that thermoelectric conversion devices are electrically serially connected so that high voltage output can be easily attained.

It is also preferable that thermoelectric conversion devices doubly or multiply enclose the through hole so that thermoelectric conversion power generation can be carried out higher efficiently by arranging on a substrate thermoelectric conversion devices which are suitable for operation temperatures determined according to positions in the radial direction on the substrate.

The method for manufacturing a thermoelectric conversion module of the present invention comprises a thermoelectric conversion device arranging step of arranging a plurality of thermoelectric conversion devices on at least one face of a substrate having a through hole extending through the surface and the back thereof as to enclose the through hole.

Using the method of the present invention, the above-described thermoelectric conversion module can be produced.

In the thermoelectric conversion device arranging step, the thermoelectric conversion devices are preferably arranged by applying a thermoelectric conversion device raw material layer containing a raw material powder of the thermoelectric conversion device and an organic binder to a prescribed area on one face of the substrate by printing or slip casting, and then firing the thermoelectric conversion device raw material layer.

In the thermoelectric conversion device arranging step, the thermoelectric conversion devices may be arranged by spraying a melted thermoelectric conversion device raw material to a prescribed area on the surface of the substrate, or by pasting the thermoelectric conversion device to a prescribed area on one face of the substrate with an adhesive.

It is preferable that the method further comprises a wiring member arranging step of arranging a wiring member for mutual connection of the thermoelectric conversion devices on the surface of the substrate, and in the wiring member arranging step a wiring member raw material layer containing a raw material powder of the wiring member and an organic binder is applied on one face of the substrate by printing or slip casting, and then the wiring member raw material layer is fired.

Further, it is also preferable that the method further comprises a wiring member arranging step of arranging a wiring member for mutual connection of the thermoelectric conversion devices on the surface of the substrate, and in the wiring member arranging step a melted wiring member raw material is sprayed onto the surface of the substrate or the wiring member is pasted onto one face of the substrate with an electrically conductive adhesive.

### BRIEF DESCRIPTION OF DRAWINGS

Fig. 1 is a schematic plane view of a thermoelectric conversion module of the present invention.
Fig. 2 shows a thermoelectric conversion unit comprising the thermoelectric conversion module in Fig. 1.
Fig. 3 is a schematic plane view of a thermoelectric conversion module of another embodiment of the present invention.
Fig. 4 is a plane view showing a method for manufacturing the thermoelectric conversion module in Fig. 1.

### EXPLANATION OF SYMBOLS

- 1: thermoelectric conversion module
- 2: substrate
- 3: wiring member
- 4, 41, 41L, 41H: p-type thermoelectric conversion device
- 4, 42, 42L, 42H: n-type thermoelectric conversion device
- 6: wiring member
- 20: tube
- 100: thermoelectric conversion unit

### Modes for Carrying Out the Invention

The finding of the present invention can be understood easily by considering the following detailed descriptions referring to appended figures shown only for exemplification. Next, embodiments of the present invention will be described referring to appended figures. If possible, the same symbol is used for the same element, and duplicated explanations are omitted.

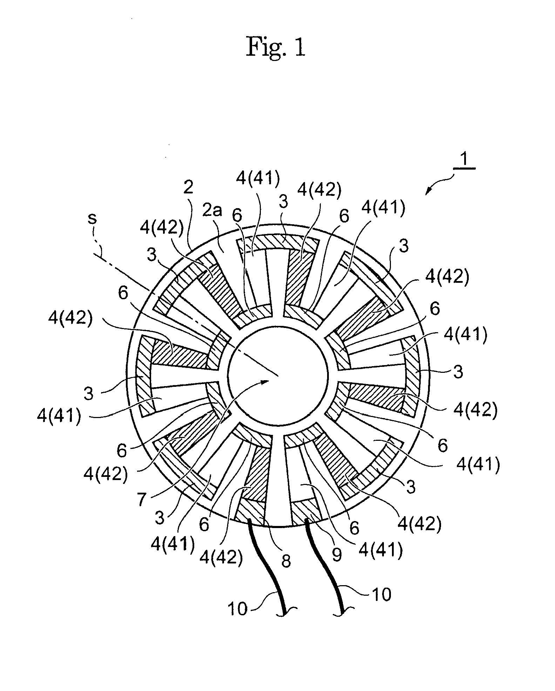

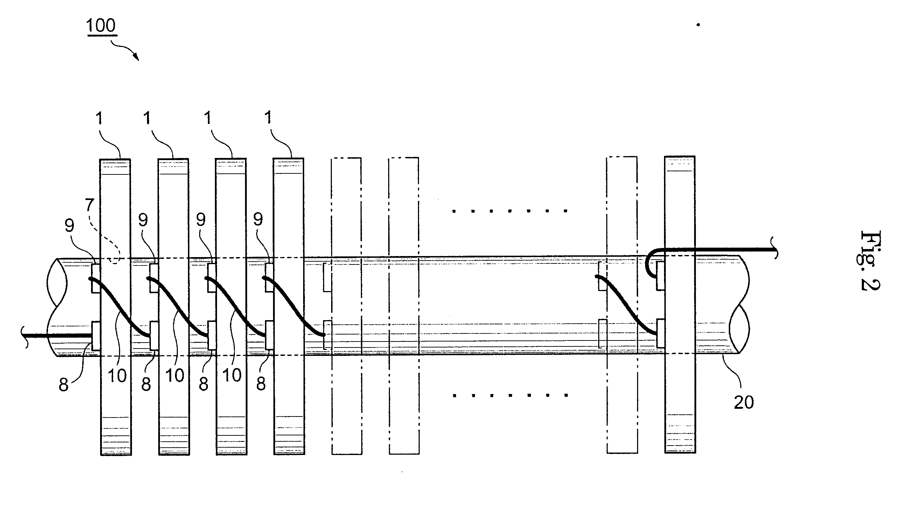

First, a thermoelectric conversion module 1 of an embodiment of the present invention will be illustrated. As shown in Fig. 1 and Fig. 2, the thermoelectric conversion module 1 has mainly a substrate 2, a plurality of thermoelectric conversion devices 4 on the surface 2a of the substrate 2, and wiring members 3 and 6 for electrically mutually connecting the thermoelectric conversion devices 4 in series.

The substrate 2 is in the form of circular disk, and has a through hole 7, for example in the form of circle, formed to extend through the surface and the back thereof, around the center position thereof. The material of the substrate 2 is not particularly limited provided that it has a high electrical insulation property and has low thermal conductivity, and examples thereof include substrates made of ceramics such as silica, alumina, magnesia, zirconia, ceria, mullite, cordierite, and calcia, and substrates made of resins such as polyester resins (for example, PET), epoxy resins, acrylic resins, and fluororesins.

The diameter and the shape of the through hole 7 are not particularly limited, and a diameter and a size suitable for the outer shape of a tube (details thereof are described later) extending through the through hole 7 may be advantageous. Also the outer diameter of the substrate 2 is not particularly limited.

The thermoelectric conversion devices 4 arranged on the surface 2a of the substrate 2 include two types: one is a p-type thermoelectric conversion device 41 and another is an n-type thermoelectric conversion device 42. The p-type thermoelectric conversion devices 41 and the n-type thermoelectric conversion devices 42 are arranged on the surface 2a of the substrate 2 so as to enclose the through hole 7 alternately. Particularly, each of the p-type thermoelectric conversion devices 41 and the n-type thermoelectric conversion devices 42 has an elongated shape, and these are arranged so that the axes s of the thermoelectric conversion devices form a radial pattern centering around the through hole when viewed in a direction vertical to the surface 2a of the substrate 2, namely, the axes s extend from the through hole 7 to the outer side of the radial direction centering around the through hole 7.

The p-type thermoelectric conversion devices 41 and the n-type thermoelectric conversion devices 42 have approximate trapezoidal shapes respectively so that as to a width along a direction crossing the axis s of the elongated shape in the thermoelectric conversion device, it is preferably that the width in a further position toward the radial direction from the center at which the through hole 7 exists is larger

Examples of the material of the p-type thermoelectric conversion device 41 include metal mixed oxides such as Ca₃CO₄O₉, and NaₓCoO₂, silicides such as MnSi_{1.73}, Fe₁₋ₓMnₓSi₂, Si_{0.8}Ge_{0.2}, and β-FeSi₂, skutterudites such as CoSb₃, FeSb₃, and RFe₃CoSb₂₂ (R represents La, Ce or Yb), Te-containing alloys such as BiTeSb, and PbTeSb, polymers such as polyacetylene, polypropylene, polyanylene, and polythiophene.

Examples of the material of the n-type thermoelectric conversion device 42 include metal mixed oxides such as SrTiO₃, Zn₁-ₓAlₓO, CaMnO₃, LaNiO₃, BaₓTi₈O₁₆, and Ti₁₋ₓNbₓO, silicides such as Mg₂Si, Fe₁₋ₓCoₓSi₂, Si_{0.8}Ge_{0.2}, and β-FeSi₂, skutterudites, clathrate compounds such as Ba₈Al₁₂Si₃₀, and Ba₈Al₁₂Ge₃₀, boron compounds such as CaB₆, SrB₆, BaB₆, and CeB₆, Te-containing alloys such as BiTeSb, and PbTeSb, polymers such as polyacetylene, polypropylene, polyanylene, and polythiophene.

Of them, thermoelectric conversion devices made of a metal mixed oxide are preferable from the standpoint of production cost and stability in air, and a combination of Ca₃Co₄O₉ as the p-type thermoelectric conversion device and CaMnO₃ as the n-type thermoelectric conversion device is particularly preferable. These thermoelectric conversion devices can be suitably used particularly in a power generator which uses a heat source of high temperature since these devices manifest a high thermoelectric property particularly at about 700 to 800°C.

Each of the p-type thermoelectric conversion devices 41 and the n-type thermoelectric conversion device 42 adjacent at one side (at clockwise direction side, in Fig. 1) to the p-type thermoelectric conversion device 41 are connected electrically with a wiring member 3 through end parts at the outer sides of the radiation direction of the respective devices. The p-type thermoelectric conversion device 41 and the n-type thermoelectric conversion device 42 adjacent at another side (at anti-clockwise direction side, in Fig. 1) to the p-type thermoelectric conversion device 41 are connected electrically with a wiring member 6 through end parts at the inner sides of the radiation direction of the respective devices. The wiring members 3 and 6 extent in the form of arc centering around the through hole. With these wiring members 3 and 6, the p-type thermoelectric conversion device 41 and the n-type thermoelectric conversion device 42 form a series circuit as a whole.

Though the materials of the wiring members 3 and 6 are not particularly limited, metals or alloys can be used. Examples of the materials of the wiring member at the relatively higher temperature side of the thermoelectric conversion module 1 include metals such as Zr, Au, Ag, Pt, Pd, Cu, Ti, Ni, Mo, Zn, W, and V, or alloys thereof. On the other hand, examples of the materials of the wiring member at the relatively lower temperature side include metals such as Bi, Sn, Ag, Cu, Pt, Al, Au, Fe, Mo, Zn, and Pb, or alloys thereof. Electrodes including the materials can be suitably used particularly in a power generator which uses a heat source of high temperature since the electrodes improve heat resistance, corrosion resistance and adhesion to a thermoelectric conversion device.

Further, at the ends of thermoelectric conversion devices 4, 4 at both ends forming a series circuit, extraction electrodes 8, 9 are formed, and leads 10 are electrically connected to the extraction electrodes 8, 9, respectively.

Next, a thermoelectric conversion unit 100 comprising the thermoelectric conversion module 1 will be illustrated referring to Fig. 2. The thermoelectric conversion unit 100 has a tube 20 and the above-described thermoelectric conversion module 1. The tube 20 is an object in which a hot medium or cold medium flows therethrough, and the temperature of the hot medium is higher than the temperature of an atmosphere around the tube 20 and the temperature of the cold medium is lower than the temperature of an atmosphere around the tube 20.

The hot medium and cold medium are not particularly limited, and examples thereof include chlorofluorocarbon, alternate chlorofluorocarbon, water, alcohols, ammonia, oils, and melted metals. The material of the tube is not particularly limited, and metals are preferable from the standpoint of thermal conductivity.

The tube 20 is so disposed as to extend through the through holes 7 of thermoelectric conversion modules 1. Preferably, the outer wall of the tube 20 is in direct contact with the inner circumference face of the through hole 7, or it is preferable that the outer wall of the tube 20 is thermally connected to the inner circumference face of the through hole 7 by an adhesive having high thermal conductivity and the like. Examples of the adhesive having high thermal conductivity include solder.

An electrode 8 of each thermoelectric conversion module 1 and an electrode 9 of the adjacent thermoelectric conversion module 1 are electrically connected through a lead 10, and one series circuit with many thermoelectric conversion devices is formed with thermoelectric conversion modules 1. In Fig. 2, the thermoelectric conversion device 4 and the wiring members 3, 6 are not shown.

In the thermoelectric conversion unit 100, when a hot medium or cold medium is supplied into the tube 20, a temperature gradient occurs in the radial direction for the substrate 2, leading to an occurrence of a temperature gradient along the length direction of the thermoelectric conversion device 4, and thus electromotive force generates for each thermoelectric conversion device, and large voltage generates between both ends of the series circuit.

Particularly in the embodiment, since a plurality of thermoelectric conversion devices 4 are arranged on the surface 2a of the substrate 2 as to enclose the through hole 7, thermoelectric conversion uses a temperature difference between the side of the though hole 7 of the substrate 2 and the side of the outer circumference face thereof can be carried out efficiently with many thermoelectric conversion devices 4 disposed with high density.

Since each of thermoelectric conversion devices 4 has an elongated shape and the devices are arranged toward the radial direction from center around the through hole 7 when viewed in a direction vertical to the surface of the substrate 2, many thermoelectric conversion devices can be arranged around the through hole efficiently, the thermoelectric conversion device with high density and high output is easily obtained.

As to a width along a direction crossing the axis s of the elongated shape in the thermoelectric conversion device 4, since the width in a further position toward the radical direction from the center around the through hole is larger when viewed in a direction vertical to the surface of the substrate so that thermoelectric conversion devices can be arranged with higher density and the surface of the substrate can be efficiently coated with thermoelectric conversion devices.

In the above-described embodiment, a plurality of thermoelectric conversion modules 1 are connected in series as shown in Fig. 2. The modules may be connected in parallel, or one thermoelectric conversion device 1 may be used.

In Fig. 1, the thermoelectric conversion devices 4 have an elongated shape and are arranged in radiating in all directions, however, the present invention is not limited to the embodiment. For example, even if the shape of the thermoelectric conversion device is square or circle, the present invention can be carried out provided that the thermoelectric conversion devices are arranged as to enclose the through hole 7. In the embodiment p-type thermoelectric conversion devices 41 and n-type thermoelectric conversion devices 42 are arranged alternately, however, either one of them may also be arranged. Depending on the voltage required, the present invention can be performed by arranging thermoelectric conversion devices 4 not in series but, for example, in parallel. Also, the outer shape of the substrate 2 may not be circular, but rectangular or the like.

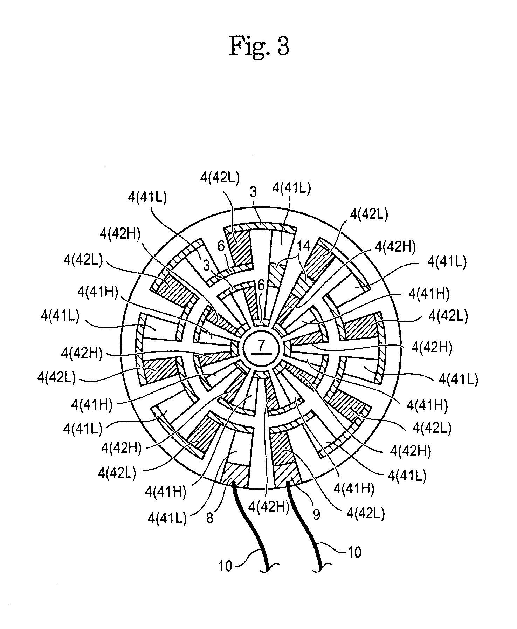

As shown in Fig. 3, the thermoelectric conversion devices 4 may also be arranged as to doubly enclose the through hole 7. When, for example, a hot medium flows through the through hole 7 to give higher temperature at the side of the through hole 7 and lower temperature at the outer circumference side of the substrate in Fig. 3, it is preferable that p-type thermoelectric conversion devices 41H for higher temperature and n-type thermoelectric conversion devices 42H for higher temperature are arranged alternately at the inner side and p-type thermoelectric conversion devices 41L for lower temperature and n-type thermoelectric conversion devices 42L for lower temperature are arranged alternately at the outer side. When a cold medium flows through the through hole 7 to give lower temperature at the side of the through hole 7 and higher temperature at the outer circumference side of the substrate, the thermoelectric conversion devices for lower temperature are used at the inner side and thermoelectric conversion devices for higher temperature are used at the outer side. The thermoelectric conversion devices which are suitable for operation temperatures determined according to positions in the radial direction on the substrate can be arranged, thus, the thermoelectric conversion of higher efficiency is attained.

In Fig. 3, the thermoelectric conversion devices 4 (41H, 42H) enclosing the through hole 7 at the inner side are electrically serially connected by wiring members 3, 6 and thermoelectric conversion devices 4 (41L, 42L) enclosing the through hole 7 at the outer side are electrically serially connected with wiring members 3, 6, further, the thermoelectric conversion devices 4 (41H, 42H) enclosing the through hole 7 at the inner side and the thermoelectric conversion devices 4 (41L, 42L) enclosing the through hole 7 at the outer side are further electrically serially connected. Thermoelectric conversion devices 4 (41H, 42H) enclosing the through hole 7 at the inner side and the thermoelectric conversion devices 4 (41L, 42L) enclosing the through hole 7 at the outer side may not be electrically serially connected. Also, thermoelectric conversion devices 4 may enclose triply or multiply the through hole 7.

It is preferable that the distance between the wiring member 3 for thermoelectric conversion devices enclosing at the inner side and the wiring member 6 for thermoelectric conversion devices enclosing at the outer side is as smaller as possible from the standpoint of thermal conductivity, and it is also effective that a material having a high electrical insulation property and thermal conductivity is sandwiched between the wiring member 3 for thermoelectric conversion devices enclosing at the inner side and the wiring member 6 for thermoelectric conversion devices enclosing at the outer side. Examples of the material include alumina, and aluminum nitride, and it is advantageous that the material is connected in the form of layer between the wiring member 3 for the thermoelectric conversion devices enclosing at the inner side and the wiring member 6 for thermoelectric conversion devices enclosing at the outer side.

Examples of the p-type thermoelectric conversion device 41H for higher temperature include metal mixed oxides such as Ca₃Co₄O₉, and examples of the n-type thermoelectric conversion device for higher temperature include metal mixed oxides such as CaMnO₃. On the other hand, examples of the p-type thermoelectric conversion device 41L for lower temperature include p-BiSbTe, and examples of the n-type thermoelectric conversion device 42L for lower temperature include n-BiSbTe.

In the above-described embodiment, thermoelectric conversion devices 4 are arranged as to enclose the through hole 7 only on one surface 2a of the substrate, however, the thermoelectric conversion devices 4 may also be arranged as to enclose the through hole 7 only on the back of the substrate 2, further, the thermoelectric conversion devices 4 may also be arranged as to enclose the through hole 7 on both of the surface and the back of the substrate.

### (Manufacturing method)

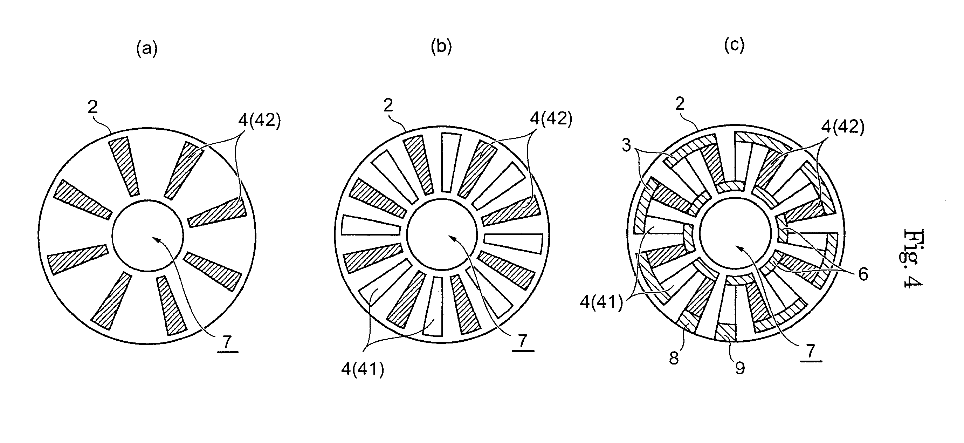

Next, an example of the manufacturing method of the above-described thermoelectric conversion module will be illustrated referring to Fig. 4. First, a substrate 2 is prepared as shown in (a). Second, thermoelectric conversion devices 4 are arranged on the substrate 2 as to enclose the through hole 7 as shown in (a) and (b).

Examples of arrangement of the thermoelectric conversion device 4 include various methods such as printing, slip casting, thermal spraying, and pasting.

In the printing, for example, a thermoelectric conversion device raw material paste containing a raw material powder of the thermoelectric conversion device, an organic binder and optionally a dispersant is prepared, and the paste is applied on a mesh or a metal plate for screen printing through a screen having an opening corresponding to the outer shape of the thermoelectric conversion device 4 to form a thermoelectric conversion device raw material layer with a prescribed size at a prescribed area. The step is called screen printing or stencil printing in some cases.

Then, the thermoelectric conversion device raw material layer is fired at high temperature to remove the organic binder and to sinter the raw material powder. When two kinds of thermoelectric conversion devices 4 including a p-type thermoelectric conversion device 41 and an n-type thermoelectric conversion device 42 are arranged as shown in Fig. 4(a) and (b), the raw material layers corresponding to the devices which have the same firing temperature may be simultaneously fired followed printing, and the raw material layers corresponding to the devices which have different firing temperatures may be fired followed printing, respectively. In the latter case, it is preferable that the raw material layer having higher firing temperature is printed and fired first.

As the raw material powder of the thermoelectric material, a raw material powder of the above-described thermoelectric materials, and a powder which is a starting material of the above-described thermoelectric materials can be used. For example, when the thermoelectric material is a mixed oxide, metal salts such as carbonates of metal can be used. Examples of the organic binder include cellulose resins such as ethyl cellulose, vinyl resins such as polyvinyl butyral, polyester resins, polyamide resins, polyurethane resins, and acrylic resins. Each of these resins may be used alone or in combination with another or more. The organic binder may contain a solvent. Examples of the solvent include solvents such as water, and alcohols.

In the slip casting, for example, a mold having an opening corresponding to the outer shape of a thermoelectric conversion device 4 is disposed on a substrate, the above-described paste is filled in the mold, fired, and then the mold is removed. Examples of the material of the mold include polyester resins such as PET, and fluorine resins such as Teflon (registered trademark).

In the thermal spraying in which a melted thermoelectric conversion device raw material is sprayed to a prescribed area on a substrate from a nozzle and the like. Example of the thermal spraying include plasma thermal spraying, and arc thermal spraying. Particularly, in the thermal spraying, a metal film can be formed also on a substrate made of a resin material such as PET.

Further, in the pasting method in which a thermoelectric conversion device cut out in the form of prescribed shape such as plate is pasted to the surface of a substrate with an adhesive usable at high temperatures. As the adhesive, inorganic adhesives such as ARON CERAMIC, and SUMICERAM can be suitably used.

Next, wiring members 3, 6 for mutual connection of thermoelectric conversion devices are arranged as shown in (c). In arranging the wiring members 3, 6, for example, an electrically conductive paste containing a wiring material and an organic binder (for example, metal pastes such as a silver paste) may be applied by printing or slip casting, and then thermally treated to form wiring members 3, 6, or a melted wiring members may be thermally sprayed, or, wiring members such as a metal foil may be adhered to the end of a thermoelectric conversion device 4 with an electrically conductive adhesive such as solder.

The present invention is not limited to the above-described embodiments, and includes a variety of embodiments.

### INDUSTRIAL APPLICABILITY

Using the present invention, there are provided a thermoelectric conversion module with a sufficient output for a tube, a thermoelectric conversion device and a manufacturing method thereof.

## Claims

1. A thermoelectric conversion module comprising a substrate and a plurality of thermoelectric conversion devices arranged on the surface of the substrate, wherein the substrate is provided with a through hole formed to extend through the surface and the back thereof, and the thermoelectric conversion devices are arranged on at least one of the surface and the back of the substrate as to enclose the through hole.

2. The thermoelectric conversion module of claim 1, wherein each of the thermoelectric conversion devices has an elongated shape, and the thermoelectric conversion devices are arranged in a radial direction centering around the through hole when viewed in a direction vertical to the one face of the substrate

3. The thermoelectric conversion module of claim 2, wherein, as to a width along a direction crossing the axis of the elongated shape in the thermoelectric conversion device, the width in a further position toward the radial direction from the center at which the through hole exists is larger when viewed in a direction vertical to the one face of the substrate is larger

4. The thermoelectric conversion module of claim 2 or 3, wherein the substrate is in the form of circular disk.

5. The thermoelectric conversion module of any one of claims 1 to 4, wherein the thermoelectric conversion devices are electrically serially connected.

6. The thermoelectric conversion module of any one of claims 1 to 5, wherein the thermoelectric conversion devices doubly or multiply enclose the through hole.

7. A thermoelectric conversion unit comprising the thermoelectric conversion module of any one of claims 1 to 6, and a tube arranged to extend through the through hole of the thermoelectric conversion module and to allow a hot medium or a cold medium to flow therethrough.

8. A method for manufacturing a thermoelectric conversion module, comprising a thermoelectric conversion device arranging step of arranging a plurality of thermoelectric conversion devices on at least one of the surface and the back of a substrate having a through hole extending through the surface and the back thereof as to enclose the through hole.

9. The method for manufacturing a thermoelectric conversion module of claim 8, wherein in the thermoelectric conversion device arranging step, the thermoelectric conversion devices are arranged by applying a thermoelectric conversion device raw material containing a raw material powder of the thermoelectric conversion device and an organic binder at a prescribed area on one face of the substrate by printing or slip casting, and then firing the resulting thermoelectric conversion device raw material layer.

10. The method for manufacturing a thermoelectric conversion module of claim 8, wherein in the thermoelectric conversion device arranging step, the thermoelectric conversion devices are arranged by spraying a melted thermoelectric conversion device raw material to a prescribed area on one face of the substrate, or by pasting the thermoelectric conversion device to a prescribed area on the surface of the substrate with an adhesive.

11. The method for manufacturing a thermoelectric conversion module of any one of claims 8 to 10, wherein the method further comprises a wiring member arranging step of arranging a wiring member for mutual connection of the thermoelectric conversion devices on one face of the substrate, and in the wiring member arranging step, a wiring member raw material layer containing a raw material powder of the wiring member and an organic binder is applied on the surface of the substrate by printing or slip casting, and then the wiring member raw material layer is fired.

12. The method for manufacturing a thermoelectric conversion module of any one of claims 8 to 10, wherein the method further comprises a wiring member arranging step of arranging a wiring member for mutual connection of the thermoelectric conversion devices on one face of the substrate, and in the wiring member arranging step, a melted wiring member raw material is sprayed onto the surface of the substrate or the wiring member is pasted onto the surface of the substrate with an electrically conductive adhesive.
